# EUROPÄISCHE PATENTSCHRIFT

(11) **EP 2 145 430 B1**
(45) Veröffentlichungstag und Bekanntmachung des Hinweises auf die Patenterteilung: **04.05.2016**
(21) Anmeldenummer: 08716670.8
(22) Anmeldetag: 22.03.2008
(51) Int. Cl.: H04L 12/40, H04L 12/417, H04L 1/00, H03M 13/09

(54) **VERFAHREN SOWIE SYSTEM ZUR SICHEREN ÜBERTRAGUNG VON ZYKLISCHEN ZU ÜBERTRAGENDEN PROZESSDATEN**
METHOD AND SYSTEM FOR THE SECURE TRANSMISSION OF PROCESS DATA TO BE CYCLICALLY TRANSMITTED
PROCÉDÉ ET SYSTÈME DE TRANSMISSION CYCLIQUE FIABLE DE DONNÉES DE PROCESSUS

(30) Priorität: 05.04.2007 DE 102007016917
(43) Veröffentlichungstag der Anmeldung: 20.01.2010
(73) Patentinhaber: Phoenix Contact GmbH & Co. KG, 32825 Blomberg (DE)
(72) Erfinder: KORREK, Andre, 37696 Marienmünster (DE)
(74) Vertreter: Bill, Burkart Hartmut
(86) Internationale Anmeldenummer: PCT/EP2008/002303
(87) Internationale Veröffentlichungsnummer: WO 2008/122355

(56) Entgegenhaltungen:
- BANNATYNE R: "TIME-TRIGGERED PROTOCOL: FAULT-TOLERANT SERIAL COMMUNICATIONS FOR REAL-TIME EMBEDDED SYSTEMS" DESIGNCON. PROCEEDINGS OF DESIGNCON, XX, XX, 1. Januar 1999 (1999-01-01), Seiten 75-83, XP001051065
- LISNER J CHR: "Scheduling in a time-triggered protocol with dynamic arbitration" INDUSTRIAL ELECTRONICS, 2005. ISIE 2005. PROCEEDINGS OF THE IEEE INTER NATIONAL SYMPOSIUM ON DUBROVNIK, CROATIA JUNE 20-23, 2005, PISCATAWAY, NJ, USA,IEEE, Bd. 4, 20. Juni 2005 (2005-06-20), Seiten 1399-1404, XP010850298 ISBN: 978-0-7803-8738-6
- THOMAS DOHMKE: "Bussysteme im Automobil CAN, FlexRay und MOST" INTERNET CITATION, [Online] XP002331425 Gefunden im Internet: URL:http://thomas.domke.de/de/projekte/bus systeme> [gefunden am 2005-06-10]

## Beschreibung

Die Erfindung betrifft ein Verfahren sowie ein System zur sicheren Übertragung von zyklischen zu übertragenden Prozessdaten.

Ein industrielles, bei Datenübertragungssystemen eingesetztes Kommunikationssystem, das eine Vielzahl von angeschlossene Feldgeräte, wie Messfühler (Sensoren), Stellglieder und/oder Antriebe (Aktoren) mit einer Steuerungseinrichtung verbindet, ist bekanntermaßen ein Feldbus, wobei die Einrichtungen, welche die tatsächliche Verbindung zum Bus bereitstellen, nachfolgend als BusTeilnehmer bezeichnet werden.

Bei einer Vielzahl von Applikationen ist hierbei die Deterministik, also die Vorbestimmtheit und Unabänderlichkeit bei der Übertragung von Prozessdaten wichtiger als die eigentliche Übertragungsgeschwindigkeit selbst. Bekannt sind beispielsweise Feldbusse mit daran angeschalteten Teilnehmern, bei welchen zum Übertragen von Prozessdaten zwischen einzelnen Teilnehmern, und also zum Senden und Empfangen von Prozessdaten, wie insbesondere Prozesseingangsdaten, Prozessausgangsdaten und Steuerungsdaten, eine zyklische Übertragung von Prozessdaten über einen gemeinsamen Übertragungskanal durchgeführt wird. Hierzu werden häufig während vorbestimmter Datenzyklen durch einen als Master fungierenden Teilnehmer protokollspezifische Daten von an Slave-Teilnehmern angeschlossenen Feldgeräten ausgelesen und während jeweils nachfolgender Datenzyklen in an Slave-Teilnehmer angeschlossene Feldgeräte hineingeschrieben.

Bei vielen Systemanwendungen sind die zu übertragenen Daten darüber hinaus zumindest teilweise sicherheitsrelevante Daten, so dass Fehler bei der Datenübertragung frühest möglichst erkannt werden müssen und bei Erkennen eines Fehlers zeitnah reagiert, z.B. ein Feldgerät, ein Teilnehmer oder ein (Teil-)System in einen sicheren Zustand gefahren werden muss. Bei einer Übertragung sicherheitsrelevanter Daten über einen Bus sind im wesentlichen sechs Fehlerklassen zu berücksichtigen. Diese betreffen die Wiederholung, den Verlust, die Einfügung, die falsche Abfolge, die Zerstörung und die Verzögerung von sicherheitsrelevanten Daten. Die Übertragung dieser Daten muss somit sicher sein.

Bannatyne beschreibt in seinem Konferenzbeitrag "Time-triggered protocol: Fault-tolerant serial communications for real-time embedded systeme", besigncon, Proceedings of Designcon, Januar 1999, Seiten 75-83, zeit-getriggerte Protokolle der Klasse C für sicherheitskritische Systeme (TTP/C). Hierbei sind gleichwertige Netzknoten an einem redundanten Bussystem angeschlossen und erhalten für bestimmte Zeitschlitze einen exklusiven Zugriff auf den Bus zum Senden von Nachrichten,

Lisner beschreibt in seinem Konferenzbeitrag "Scheduling in a tme-triggered protocol with dynamic arbitration", Industrial Electronics, 2005, ISIE 2005, Proceedings of the IEEE International Symposium, Dubrovnik, Kroatien, Juni 20-23 2005, Band 4, Seiten 1399-1404, ISBN: 978-0-7803-8738-6, ein Protokoll namens Tea, das Zeitschlitze von dynamischer Länge zulässt. Dieses Protokoll sieht eine flexible Zuweisung von Zeitschlitzen vor, die über ein statisches vorkonfiguriertes Vergabeverfahren hinausgeht.

Um eine sichere Übertragung von Daten, insbesondere von sicherheitsrelevanten Prozessdaten, zumindest derart zu gewährleisten, dass die aufgeführten Fehlerklassen bei vorliegen auch erkannt werden können, ist es grundsätzlich gängige Praxis, die übertragenen Daten mit zusätzlichen Kontrolldaten, wie beispielsweise Zeitstempel, Teilnehmerinformation und/oder Checkinformation, z.B. CRCs (Cycle Redundancy Check) zu erweitern. Ein entscheidender Nachteil hierbei ist jedoch, dass der zu übertragende Overhead gegenüber den zu übertragenden Nutzdaten herkömmlicherweise stark ansteigt und dadurch die Protokolleffizienz abnimmt. Besonders eklatant wird diese Schwäche, wenn nur wenige und/oder nur selten sicherheitsrelevante Nutzdaten pro Teilnehmer übertragen werden müssen.

Eine Aufgabe der Erfindung ist es daher, einen Weg zur Übertragung von Prozessdaten über einen gemeinsamen Übertragungskanal aufzuzeigen, der auch bei Applikationen, bei denen die Äquidistanz der Abtastung selbst sowie die Deterministik bei der Übertragung von Daten wichtige Kriterien sind, die sichere Übertragung von Daten im Bedarfsfall gewährleistet, ohne dass die Protokolleffizienz hierbei wesentlich beeinflusst wird.

Die erfindungsgemäße Lösung ist durch einen jeweiligen Gegenstand mit den Merkmalen eines anhängenden unabhängigen Anspruchs gegeben.

Vorteilhafte und/oder bevorzugte Ausführungsformen und Weiterbildungen sind Gegenstand der jeweiligen Unteransprüche.

Die Erfindung sieht somit ein Verfahren und ein System zur sicheren Übertragung von zyklisch zu übertragenen Prozessdaten vorgesehen, bei welchen über einen Übertragungskanal eine protokollspezifisch zyklische Datenübertragung wenigstens zwischen einem als Master fungierenden Teilnehmer und wenigstens einem als Slave fungierenden Teilnehmer durchgeführt wird. Innerhalb eines Übertragungsprotokollrahmens wird jedem Slave während eines Datenübertragungszyklus ein Datenbereich bzw. Zeitschlitz zugeordnet, der unabhängig von den zu übertragenden Daten stets die gleiche Anzahl von Bits aufnehmen kann, wobei jeder Datenaustauschzyklus durch den Bus-Master mit der Übertragung einer Adresse und eines Funktionscodes eingeleitet wird. Für sicherheitsrelevante Prozessdaten, die während eines Datenübertragungszyklus von einem Slave sicher an wenigstens einen weiteren Teilnehmer übertragen werden sollen oder die während eines Datenübertragungszyklus von einem Teilnehmer sicher an wenigstens einen Slave übertragen werden sollen, werden zur Erkennung einer fehlerfreien Übertragung dieser sicherheitsrelevanten Prozessdaten jeweils zusätzlich erste Sicherungsdaten generiert und mit übertragen, wobei die sicher zu übertragenen Prozessdaten gemeinsam mit den jeweils hierfür generierten ersten Sicherungsdaten in dem, dem jeweiligen Slave zugeordneten Datenbereich bzw. Zeitschlitz eingebettet werden.

Die Äquidistanz der Abtastung sowie die Deterministik bei der Übertragung von Prozessdaten bleibt somit erhalten und der grundsätzliche Nutzdatendurchsatz für Standard-Prozessdaten wird dadurch nicht geschmälert. Ferner werden durch die Erfindung Teilnehmer, die eine derartige sichere Datenübertragung nicht kennen bzw. nicht unterstützen, hierdurch nicht beeinflusst.

Gemäß einer besonders zweckmäßigen Weiterbildung ist ferner vorgesehen, die ersten Sicherungsdaten unter Verwendung von Sicherheitsdaten zu generieren, die während eines zyklisch vorhergehenden Datenübertragungszyklus von einem vorgegebenen Sicherheitsteilnehmer über den Übertragungskanal gesendet werden.

Folglich kann durch die Erfindung bei nur geringem Overhead auf besonders effektive Weise eine Fehlererkennung sichergestellt werden, welche auch bei sich von einem Datenübertragungszyklus zu einem nachfolgenden Datenübertragungszyklus nicht ändernden sicherheitsrelevanten Prozessdaten eine Dynamik bewirkt, die im Wesentlichen alle während einer Übertragung möglichen Fehler mit höchster Sicherheit aufdeckt.

In besonders zweckmäßiger Weiterbildung ist vorgesehen, hierzu ein sich zyklisch mit jedem Datenübertragungszyklus änderndes Laufdatum einzusetzen, wodurch sichergestellt ist, dass zwei aufeinanderfolgende Datenübertragungszyklen niemals die gleichen Daten innerhalb des Übertragungsprotokollrahmens beinhalten dürfen.

Vorzugsweise wird dieses Laufdatum auch nach der fehlerhaften Übertragung eines Übertragungsprotokollrahmens im nächsten Zyklus geändert, so dass also auch auf einfachste Weise der dieses Laufdatum generierende Teilnehmer selbst im Rahmen der sicheren Übertragung auf Fehler hin überwacht werden kann.

Eine zweckmäßige Weiterbildung sieht ferner vor, dass in dem Datenbereich bzw. Zeitschlitz des die Sicherheitsdaten generierenden Sicherheitsteilnehmer zusätzlich Prozessdaten für Teilnehmer, die sicherheitsrelevante Prozessdaten. bearbeiten können, eingebettet werden.

Eine bevorzugte Ausführungsform sieht hierbei vor, dass als zusätzliche Prozessdaten in diesen Zeitschlitz Steuerungsdaten eingebettet werden. Hierdurch können beispielsweise ausgewählte sicherheitsrelevante Prozessdaten bearbeitende Teilnehmereinheiten einschließlich diesen nachgeschalteten Einheiten freigegeben oder gesperrt werden.

Zur weiteren Erhöhung der Sicherheit ist bevorzugt darüber hinaus vorgesehen, dass auch die Sicherheitsdaten des Sicherheitsteilnehmers durch Sicherungsdaten gesichert werden.

Von Vorteil ist ferner, zur Generierung von Sicherheitsdaten wenigstens eine Kennung einzubeziehen, die einen jeweils sicherheitsrelevante Prozessdaten verarbeitenden Slave-Teilnehmer identifiziert, so dass insbesondere auch eine falsche Abfolge bei der Übertragung sicherheitsrelevanter Daten erkennbar ist.

Bevorzugte Ausführungsformen sehen darüber hinaus vor, dass jeder Übertragungsprotokollrahmen insgesamt mit Sicherungsdaten, die unter Verwendung aller darin enthaltenen Daten generiert werden, abgesichert wird.

Vorzugsweise sind die Zeitschlitze, die Teilnehmern zugeordnet sind, welche sicherheitsrelevante Prozessdaten verarbeiten können, innerhalb des Übertragungsprotokollrahmens vor Zeitschlitzen angeordnet, die Teilnehmern zugeordnet sind, welche keine sicherheitsrelevanten Prozessdaten verarbeiten können.

Weitere Vorteile und Merkmale der Erfindung ergeben sich aus der nachfolgenden Beschreibung einer beispielhaften Ausführungsform der Erfindung unter Bezugnahme auf die beigefügten Zeichnungen, in denen zeigen:
- Fig. 1: einen grundsätzlichen Systemaufbau, welcher für die Erfindung einsetzbar ist,
- Fig. 2: ein bevorzugter Rahmenaufbau für ein erfindungsgemäß verwendbares Telegramm,
- Fig. 3: einen Rahmenaufbau gemäß der Erfindung während eines Datenaustauschszugriffs,
- Fig. 4: ein "Safety-Control-PDC" gemäß der Erfindung, und
- Fig. 5: ein "Safety-Data-PDC" gemäß der Erfindung.

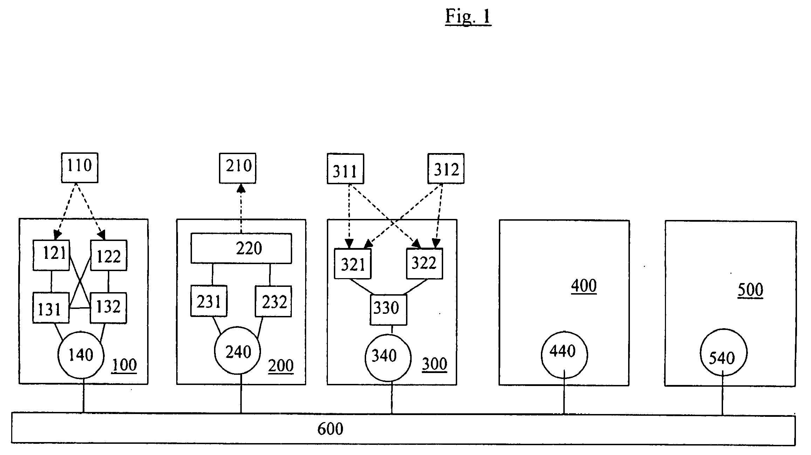

Nachfolgend wird zunächst auf Fig. 1 Bezug genommen, welche einen grundsätzlichen, im Rahmen der Erfindung einsetzbaren Systemaufbau zeigt. Der dargestellte Systemaufbau gestaltet sich topologisch betrachtet als Linie, wobei jedoch auch eine Sterntopologie oder beliebige Mischformen denkbar sind.

Zu sehen sind fünf an einen Bus 600 angeschaltete BusTeilnehmer. Ein erster Busteilnehmer ist ein sicherheitsgerichteter Master 100, nachfolgend auch als Safety-Master bezeichnet, der im vorliegenden Beispiel gleichzeitig auch der Bus-Master ist, wobei dieses im Rahmen der Erfindung jedoch nicht zwingend ist. Es kann sich hierbei allgemein um einen bestimmten, entsprechend vorgegebenen Sicherheitsteilnehmer handeln. Ein zweiter und dritter Busteilnehmer ist ein sicherheitsgerichteter Slave-Ausgangsteilnehmer 200, nachfolgend auch als Safety-Output-Slave bezeichnet, bzw. ein sicherheitsgerichteter Slave-Eingangsteilnehmer 300, nachfolgend auch als Safety-Input-Slave bezeichnet. Ein vierter und fünfter Busteilnehmer ist ein nicht sicherheitsgerichteter Slave-Ausgangsteilnehmer 400, nachfolgend auch als Output-Slave bezeichnet, bzw. ein nicht sicherheitsgerichteter Slave-Eingangsteilnehmer 500, nachfolgend auch als Input-Slave bezeichnet. Sicherheitsgerichtete Teilnehmer, d.h. Teilnehmer, welche sicherheitsrelevante Prozessdaten verarbeiten, und nicht sicherheitsgerichtete Teilnehmer können somit gemischt werden und auch beliebig angeordnet sein.

Hinsichtlich der sicherheitsgerichteten Teilnehmer des dargestellten beispielhaften Systemaufbaus ist an den Safety-Master 100 z.B. ein Not-Aus-Schalter 110 angeschaltet, dessen sicherheitsrelevante Eingangsinformation der Teilnehmer 100 über zwei Eingänge 121 und 122 redundant erhält und protokollspezifisch zunächst über zwei redundante Verarbeitungskanäle 131 und 132 verarbeitet, bevor eine Signalankopplung an den Bus 600 erfolgt. An den Safety-Output-Slave 200 ist z.B. ein Motor 210 angeschaltet, wobei der Teilnehmer 200 nach einer Signalauskopplung vom Bus 600 zunächst protokollspezifisch eine Verarbeitung über zwei redundante Verarbeitungskanäle 231 und 232 durchführt und die sicherheitsrelevante Ausgangsinformation an den Motor 210 über einen Ausgang 220 gibt. An den Safety-Input-Slave 300 sind z.B. eine Schutztür 311 und ein Drehzahlgeber 312 angeschaltet, deren sicherheitsrelevante Eingabeinformation der Teilnehmer 300 über zwei Eingänge 321 und 322 redundant erhält und protokollspezifisch über einen Verarbeitungskanal 331 verarbeitet, bevor eine Signalankopplung an den Bus 600 erfolgt.

Die Realisierung einer sicherheitsgerichteten Funktion erfolgt somit in der Regel unter Nutzung einer redundanten Verarbeitung, z.B. durch zwei harwareseitig von einander getrennte Kanäle, wobei die jeweilige Schnittstelle 140, 240, 340, 440 bzw. 540 eines Teilnehmers zum Bus 600 in der Regel nur einkanalig realisiert ist. Neben einer Reduzierung des benötigten Platzes und der Kosten können hierdurch auch die doppelte Anzahl an Teilnehmern am Bus, insbesondere hinsichtlich Buslast, Stromaufnahme und Kapazität, betrieben werden. Fehler, die durch die Busankopplung, z.B. basierend auf Leitungstreiber, galvanischer Trennung, verursacht werden, können üblicherweise durch das verwendete Leitungsprotokoll erkannt werden. Die Verarbeitungseinheit der sicherheitsgerichteten Teilnehmer muss hardwareseitig jedoch nicht zwangsläufig zweikanalig ausgebildet sein, sondern in vielen Fällen reicht es auch, wenn die Software zweikanalig ausgeführt ist.

Der Bus 600 stellt nunmehr die gemeinsame Datenleitung für das erfindungsgemäße Verfahren und Übertragungssystem zum Senden und Empfangen von allen Daten, insbesondere von Prozessdaten bereit. Beispielsweise basierend auf einem aus der Automobiltechnik bekannten LIN-Bus arbeitet ein derartiges gattungsbildendes Übertragungssystem, bei welchem während bestimmter Datenzyklen durch einen Master protokollspezifische Daten von über Teilnehmer angeschlossenen Feldgeräten ausgelesen und während jeweils nachfolgender Datenzyklen in solche hineingeschrieben werden können, mit etwa 19,2 bis 38 kbd.

Die Erfindung macht sich zu eigen, dass für viele Applikationen die Deterministik, also die Vorbestimmtheit und Unabänderlichkeit bei der Übertragung von Prozessdaten wichtiger ist als die eigentliche Übertragungsgeschwindigkeit selbst. Diese Deterministik wird durch die Buszykluszeit des Übertragungssystems bestimmt, welche zweckmäßigerweise einstellbar ist und beispielsweise in einem Bereich zwischen 10 und 100 ms liegt. Für eine Übertragung von 16 Prozessdatenwerten ä 16 Bit pro Zyklus ist folglich eine Defaulteinstellung von z.B. 25 ms ausreichend.

Beim einem beispielhaften Verfahren nach der Erfindung erfolgt somit die Übertragung von Prozesseingangs- und - ausgangsdaten grundsätzlich auch in einem festen Intervall, jeweils um die halbe Buszykluszeit versetzt. Ein Übertragungsprotokoll für die zyklische Übertragung von Prozesseingangs- und -ausgangsdaten verwendet somit häufig zwei unterschiedliche Datenaustauschdienste, nachfolgend auch als Data-Exchange-Mode bezeichnet. Ein Buszyklus umfasst in diesem Fall folglich einen auf einem PD-Read-Dienst basierten Datenzyklus und einen nachfolgenden Datenzyklus, der auf einem PD-Write-Dienst basiert.

Bei der Übertragung von Prozessausgangsdaten sendet ein Master den mit diesem verbundenen Teilnehmern beim PD-Write-Dienst grundsätzlich alle Daten für die angeschlossenen Feldgeräte und ermittelt zweckmäßigerweise anschließend einen CRC (Cyclic Redundancy Check), den er auch überträgt. Zweckmäßigerweise ist das Übertragungssystem derart ausgebildet, dass alle angeschlossenen Teilnehmer alle so übertragenden Informationen mitlesen und bevorzugt ebenfalls einen CRC bilden, den sie mit dem empfangenen CRC des Masters vergleichen, so dass im Fehlerfall eine Fehlermeldung generiert und beispielsweise ausgewählte Teilnehmer oder einzelne Feldgeräte in einen sicheren Zustand gefahren werden. Bei der Übertragung der Prozesseingangsdaten sendet der Master bei einem PD-Read-Dienst z.B. zunächst eine Broadcast-Adresse gefolgt von einem Funktionscode. Die weiteren angeschlossenen Teilnehmer legen daraufhin Daten ihrer angeschalteten Feldgeräte, also insbesondere ihre Prozesseingangsdaten Bit für Bit auf die Datenleitung in jeweils dafür vorgesehene Zeitschlitze. In bevorzugter Ausführung sind die Teilnehmer wiederum in der Lage durch Mithören auf der Datenleitung alle Daten zu erkennen und hierfür wiederum einen CRC zu berechnen.

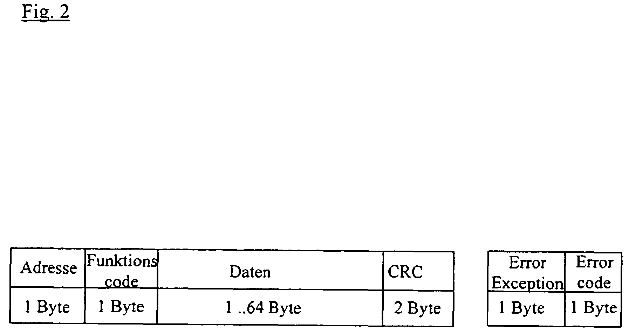

Ein bevorzugter, jedoch grundsätzlich protokollabhängiger Rahmenaufbau für das erfindungsgemäße Verfahren während eines Datenaustauschdienstes oder -zyklusses ist in Fig. 2 dargestellt. Die jeweilige Telegrammlänge umfasst hierbei z.B. 68 Zeichen. Das während eines Datenaustauschdienstes oder -zyklusses übertragene Telegramm umfasst demgemäß eine Adresse von einem Byte, die einen bestimmten Teilnehmer oder im Falle einer Broadcast-Adresse alle Teilnehmer als Empfänger bestimmt. Anschließend folgt ein Funktionscode, im vorliegenden Fall ebenfalls ein Byte umfassend, der die beabsichtigte Funktion der nachfolgenden Nutzdaten definiert. Die eigentlichen Nutzdaten umfassen im vorliegenden Beispielsfall 64 Byte gefolgt von einem 2-Byte-umfassenden CRC. Zwischen den einzelnen Zeichen eines solchen Telegramms darf während der Übertragung eine maximale Pause nicht überschritten werden, da ansonsten auf einen Fehler erkannt werden würde. Diese Pause ist z.B. mit 1 ms vorgegeben und wird auch als Inter-Charakter-Timeout bezeichnet. Zwischen zwei aufeinanderfolgenden Telegrammen kann darüber hinaus eine Ruhezeit (Inter-Frame-Timeout) vorgesehen sein, beispielsweise von 2 ms, damit die gegebenenfalls nötige Fehlerbehandlung korrekt vom Empfänger durchgeführt werden kann. Eine Rückübertragung eines wie bei Fig. 2 dargestellten Error-Exception-Codes und eines Error-Codes, also der Mitteilung, dass ein Fehler erkannt worden ist und welcher Fehler erkannt worden ist, durch den Empfänger erfolgt bevorzugt nur bei Erkennen eines solchen Fehlers und beginnt zweckmäßigerweise zwischen einer und zwei Millisekunden nach dem vom Empfänger erhaltenen CRC des Senders.

Wie vorstehend bereits aufgezeigt, basiert die Erfindung somit auf einem zyklisch aufgebauten Datenaustausch, der in einem fest definierten Raster stattfindet und z.B. in den vorgenannten PD-Read- und den PD-Write-Zugriff beziehungsweise -Zyklus unterteilt ist, so dass mit dem PD-Write-Zugriff Daten vom Master zu Slaves gesendet und mit dem PD-Read-Zugriff in die andere Richtung, also im Wesentlichen von Slaves zum Master gesendet werden. Für die nachfolgende Beschreibung sei ferner angenommen, dass ein jeweiliges Prozessdatum aus 16 Bit besteht und als Prozessdatenkanal (PDC) bezeichnet wird. Jedem Teilnehmer ist hierbei wenigstens ein bestimmter Prozessdatenkanal (PDC) fest zugeordnet.

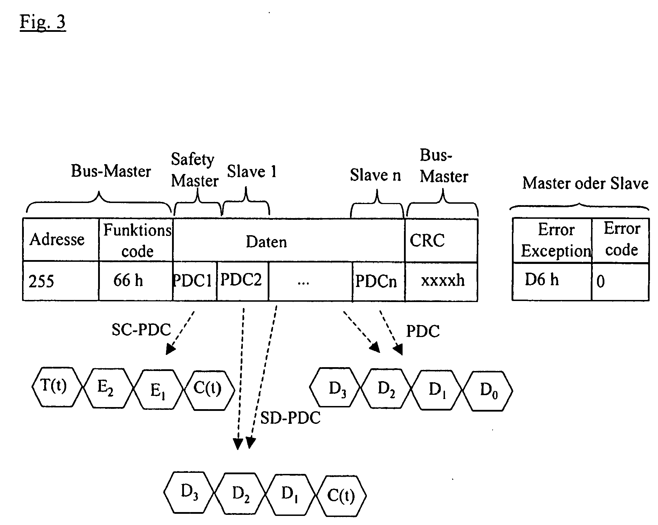

Jeder Datenaustauschzyklus wird, wie bei Fig. 3 zu sehen durch den Bus-Master mit der Übertragung einer Adresse und eines Funktionscodes eingeleitet. Im Anschluss daran werden die PDC's generiert und eingelesen. Sind alle PDC's eingelesen, generiert der Master eine Checksumme CRC. Alle Teilnehmer berechnen ebenfalls eine Checksumme und vergleichen sie mit der vom Master-Teilnehmer generierten. Erkennt wenigstens ein Teilnehmer einen Unterschied, wird z.B. die bei Fig. 3 dargestellte Fehlerantwort generiert und alle Teilnehmer verwerfen gemäß bevorzugter Ausfilhrungsform, nach der alle Teilnehmer alle Daten mitlesen, die Daten dieses letzten Zyklusses. Für die Generierung der Checksumme ist es ferner zweckmäßige, dass die Produzenten diese nicht mit den Daten, die sie vom Bus zurücklesen, sondern mit denen, die sie an den Bus übertragen durchführen, da nur so eine vollständige Überwachung gewährleistet ist.

Der Aufbau eines Protokollrahmens, wie bei Fig. 3 dargestellt, muss sich somit gegenüber der Offenbarung der vom selben Anmelder am 04.11.2005 eingereichten Deutschen Patentanmeldung Nr. 10 2005 053 103.2 mit der Veröffentlichungsnummer DE 10 2005 053 103 A1 mit dem Titel "Verfahren sowie System zur Übertragung von zyklischen und azyklischen Daten" nicht unterscheiden.

Die Unterscheidung, also insbesondere in Ergänzung oder Alternative zu vorstehend in Bezug genommener Offenbarung befindet sich im Nutzdatenbereich, d.h. den PDCs.

Der erste PDC ist dem Safety-Master zugeordnet, und kann entsprechend als sicherheitsrelevanter Steuerungs-PDC oder Safety-Control-PDC bezeichnet werden. Ein bevorzugter grundsätzlicher Aufbau des Safety-Control-PDC ist bei Fig. 3 herausgelöst aus dem Protokollrahmen dargestellt und mit "SC-PDC" gekennzeichnet. Dieser "SC-PDC" wird gemäß der Erfindung vom Safety-Master generiert. Im Anschluss an den vom Safety-Master generierten Safety-Control-PDC werden die PDCs der "normalen" Slave-Teilnehmer übertragen. Der bei Fig. 3 dargestellte zweite PDC ist einem Safety-Input-Slave oder einem Safety-Output-Slave zugeordnet, und kann entsprechend als sicherheitsrelevanter Daten-PDC oder Safety-Data-PDC bezeichnet werden. Ein bevorzugter grundsätzlicher Aufbau des Safety-Data-PDC ist bei Fig. 3 herausgelöst aus dem Protokollrahmen dargestellt und mit "SD-PDC" gekennzeichnet. Der bei Fig. 3 dargestellte letze PDC ist einem Input-Slave oder einem Output-Slave zugeordnet. Ein bevorzugter grundsätzlicher Aufbau des nicht sicherheitsrelevante Daten umfassenden PDCs ist bei Fig. 3 ebenfalls herausgelöst aus dem Protokollrahmen dargestellt und lediglich mit "PDC" gekennzeichnet. Dieser nicht sicherheitsrelevante Daten umfassende PDC umfasst gemäß Darstellung einen in vier Nibbeln D₃, D₂, D₁ und D₀ untergliederten Prozessdatenwert von 16 Bit.

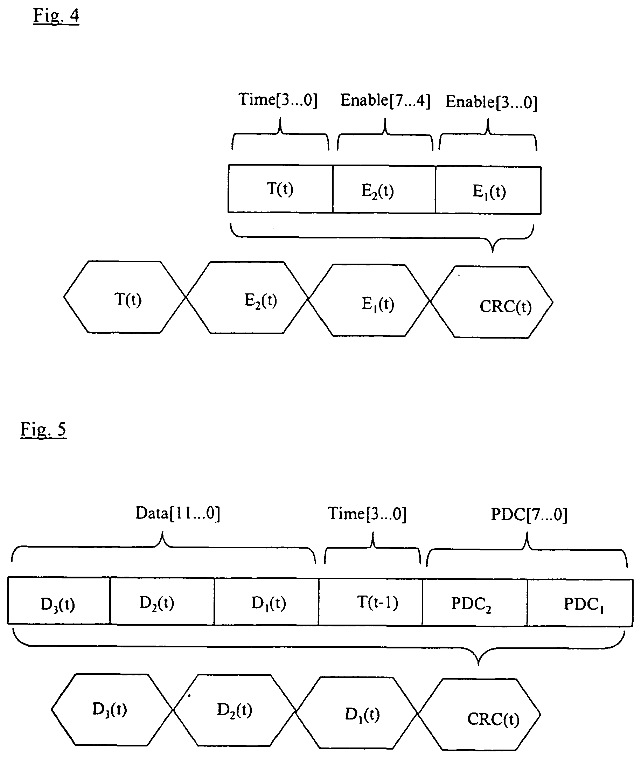

Nachfolgend wird auf Fig. 4 Bezug genommen, welche den Aufbau eines Safety-Control-PDC, bei Fig. 3 mit SC-PDC bezeichnet, detaillierter zeigt.

Das Safety-Control-PDC stellt gemäß besonders bevorzugter Ausführungsform der Erfindung ein zentrales Element für die Sicherung der Datenübertragung als auch für die Realisierung der erfindungsgemäßen Sicherheitsfunktion bereit. Das Safety-Control-PDC gliedert sich in die gleiche Anzahl von Teileinheiten mit einer jeweiligen gleichen Anzahl von Bits, wie jedes andere PDC auch. Im vorliegenden Beispiel also in vier Teile mit jeweils vier Bits. Das höchstwertige Nibbel liefert ein Laufdatum oder Laufindex T(t). Dieser Laufindex wird vom Safety-Master jeweils aus vier Bit, bei Fig. 4 auch mit Time[3..0] angezeigt, generiert und mit jedem Buszyklus verändert. Auch wenn die Übertragung eines Telegrammrahmens fehlerhaft verlaufen sein sollte, wird der Laufindex mit dem nächsten Zyklus verändert. Auf diese Weise wird gewährleistet, dass zwei aufeinanderfolgende Datenübertragungen niemals das gleiche Datenwort beinhalten. Die zwei nachfolgenden niederwertigeren Nibbel enthalten z.B. Freigabeinformation E₂(t) und E₁(t), mit denen der Safety-Master Sicherheitskreise unabhängig und individuell steuern kann. E₂(t) und E₁(t) umfassen jeweils wieder vier Bits, bei Fig. 4 für E₂(t) mit Enable[7..4] und für E₁(t) mit Enable [3..0] angezeigt, so dass insgesamt acht von einander unabhängige Sicherheitskreise gesteuert werden können, wobei ein jeweiliger Sicherheitskreis freigegeben oder gesperrt ist, wenn das zugehörige Bit gesetzt bzw. zurückgesetzt ist.

Die vorbeschriebenen Daten des Safety-Control-PDC werden durch einen 4 Bit umfassenden CRC gesichert, der über diese Daten gebildet wird und im niederwertigsten Nibbel übertragen wird. Der Safety-Control-PDC wird von den Safety-Slaves akzeptiert und somit als gültig erkannt, wenn der übertragene CRC mit einem selbst über die Daten T(t), E₂(t) und E₁(t) berechneten CRC übereinstimmt und er sich seit dem letzten Datenaustausch in mindestens einem Bit verändert hat. Teilnehmer, die diese Betriebsart nicht kennen oder nicht unterstützen werden hierdurch nicht beeinflusst.

Nachfolgend wird auf Fig. 5 Bezug genommen, welche den Aufbau eines Safety-Data-PDCs, bei Fig. 4 mit SD-PDC bezeichnet, detaillierter zeigt.

Im Gegensatz zu Daten die mit einem Standard-PDC, bei Fig. 3 mit PDC bezeichnet, übertragen werden, welcher im vorliegenden Beispiel 16 Nutzdatenbits umfasst, besteht im Fall eines erfindungsgemäßes Safety-Data-PDCs dieser aus nur 12 Nutzdatenbits. Die weiteren vier.Bits, bevorzugt die vier niederwertigsten Bits werden analog zum Safety-Control-PDC zur Übertragung von CRC-Information genutzt. Die Generierung der CRC-Information erfolgt aber nicht nur aus den sicher zu übertragenden Nutzdatenbits D3(t), D2(t) und D1 (t), welche aus insgesamt 12 Bits, bei Fig. 5 mit Data[11..0] angezeigt, aufgebaut sind. Zusätzlich wird noch weitere Information zur Generierung der CRC-Information mit einbezogen, wobei hierbei jedoch die weitere Information nicht mit übertragen werden muss sondern diese den Teilnehmern zum Zeitpunkt der Generierung der CRC-Information grundsätzlich bereits bekannt ist. Diese zusätzliche, mit in die Berechnung mit einbezogenen Informationen umfaast bevorzugt Information aus einem vorherigen Übertragungszyklus, wie z.B. der Laufindex T(t-1) aus dem unmittelbar letzten gültigen Übertragungszyklus, und jeweils vorgegebene PDC Daten von vorgegebenen PDCs, wie z.B, den Nummern der PDC2 und PDC1, als weitere Sicherungskennung. Auch hier gilt, dass die Daten des Safety-Data-PDCs nur gültig sind, wenn der übertragene CRC mit dem vom konsumierenden Teilnehmer berechneten CRC übereinstimmt und die PDCs eines produzierenden Teilnehmers zu zwei aufeinanderfolgenden Übertragungszyklen ungleich sind, also SD-PDC(x,t) und SD-PDC(x,t-1) ungleich sind. Teilnehmer, die diese Betriebsart nicht kennen oder nicht unterstützen werden hierdurch wiederum nicht beeinflusst.

Insgesamt liegt somit ein wesentlicher Vorteil der Erfindung darin, dass eine deutliche Reduzierung des Overheads zur Datensicherung und Fehlererkennung benötigt wird, da die zur Sicherung und Fehlererkennung zusätzlich notwendige Information nicht zyklisch mit den zu sichernden Nutzdaten mit übertragen werden muss sondern aus System-, Master- und/oder Safety-Masterinformation generiert wird. Dies führt folglich zusammen mit dem einfachen Systemaufbau dazu, dass jeder sicherheitsgerichtete Busteilnehmer eine Prüfung der sicherheitsrelevanten Daten- und Systemintegrität durchführen kann. Die Sicherheitsfunktionen können auf Teilnehmerseite somit einkanalig ausgeführt werden, da das Gesamtsystem für die nötige Fehlertoleranz sorgt.

Zusammenfassend setzt die Erfindung somit auf folgende grundsätzlichen Merkmale auf. Mittels eines Telegramms werden Daten von einer Datenquelle zu wenigstens einer angeschlossenen Datensenke übertragen. Im Datenbereich des Telegramms finden sich an erster Stelle die Daten eines Sicherheitsmasters, welche eine Lauf-, insbesondere Zeitinformation, Nutzdaten und einen geeigneten Check (CRC) umfassen. Alle angeschlossenen Slaves lesen zweckmäßig die Daten mit und ermitteln ihrerseits einen Gesamt-CRC, der über alle gesendeten Daten berechnet wird und beim Senden des Telegramms vom Bus-Master angehängt wird.
Erkennt wenigstens ein Teilnehmer einen Fehler, so erzeugt dieser ein Fehlertelegramm. Der Inhalt des Fehlertelegramms ist untergeordnet, maßgeblich ist lediglich, dass die im Bussystem vorgesehene Ruhezeit verletzt wird. Ist dies der Fall, so wird das Telegramm als fehlerhaft eingestuft und verworfen. Den Slaves ist jeweils ein Zeitschlitz zugeordnet, der auf den Zeitschlitz des Sicherheitsmasters folgt. Die Slaves können während eines entsprechenden Daten-Exchange-Modus ihrerseits in dem jeweils zugeordneten Zeitschlitz eine Anzahl von Nutzdatenbits versenden und gegebenenfalls unter geringfügiger Einbuße von Nutzdatenbits diese zusätzlich gesichert versenden, wobei sie diese hierzu mit einem Check (CRC) absichern, der auch in dem jeweils zugeordneten Zeitschlitz versendet wird. Dieser Check wird über die verbleibenden Nutzdatenbits, sowie über zusätzliche, den Teilnehmern bereits bekannte Information gebildet. Diese zusätzliche Information umfasst bevorzugt Lauf-, insbesondere Zeitinformation aus dem vorherigen Zyklus und wenigstens eine Prozessdatennummer. Durch die Integration der Laufinformation ist insbesondere auch gewährleistet, dass statische Fehler erkannt werden können, da sich immer etwas, d.h. wenigstens ein Bit ändern muss.

## Patentansprüche

1. Verfahren zur sicheren Übertragung von zyklisch zu übertragenen Prozessdaten bei einer über einen Übertragungskanal protokollspezifisch durchzuführenden zyklischen Datenübertragung wenigstens zwischen einem als Bus-Master fungierenden Teilnehmer und wenigstens einem als Slave fungierenden Teilnehmer, welche an den Übertragungskanal angeschaltet sind, wobei innerhalb eines Übertragungsprotokollrahmens jedem Slave während eines Datenübertragungszyklus ein Zeitschlitz zugeordnet wird, der unabhängig von den zu übertragenden Daten stets die gleiche Anzahl von Bits aufnehmen kann,
**dadurch gekennzeichnet, dass**
jeder Datenaustauschzyklus durch den Bus-Master mit der Übertragung einer Adresse und eines Funktionscodes eingeleitet wird, wobei
für sicherheitsrelevante Prozessdaten, die während eines Datenübertragungszyklus von einem Slave sicher an wenigstens einen weiteren Teilnehmer übertragen werden sollen oder die während eines Datenübertragungszyklus von einem Teilnehmer sicher an wenigstens einen Slave übertragen werden sollen, zur Erkennung einer fehlerfreien Übertragung dieser sicherheitsrelevanten Prozessdaten jeweils zusätzlich erste Sicherungsdaten generiert und mit übertragen werden, wobei die sicher zu übertragenen Prozessdaten gemeinsam mit den jeweils hierfür generierten ersten Sicherungsdaten in dem, dem jeweiligen Slave zugeordneten Zeitschlitz eingebettet werden.

2. Verfahren nach vorstehendem Anspruch, ferner **dadurch gekennzeichnet, dass** ein Teilnehmer als Sicherheitsteilnehmer fest vorgegeben wird, und die ersten Sicherungsdaten unter Verwendung von Sicherheitsdaten generiert werden, die während eines zyklisch vorhergehenden Datenübertragungszyklus von dem Sicherheitsteilnehmer über den Übertragungskanal übertragen und zumindest von Teilnehmern, die sicherheitsrelevante Prozessdaten verarbeiten können, während des Übertragungszyklus mitgelesen werden.

3. Verfahren nach vorstehendem Anspruch, ferner **dadurch gekennzeichnet, dass** dem Sicherheitsteilnehmer innerhalb des Übextragungsprotokollrahmens ein Zeitschlitz fest zugeordnet wird, wobei die zur Generierung der ersten Sicherungsdaten verwendeten Sicherheitsdaten des Sicherheitsteilnehmers in dem diesem zugeordneten Zeitschlitz eingebettet werden und ein sich zyklisch mit jedem Datenübertragungszyklus änderndes Laufdatum umfassen, wobei dieser Zeitschlitz zumindest von Teilnehmern, die sicherheitsrelevante Prozessdaten verarbeiten können, während des Übertragungszykluß mitgelesen wird.

4. Verfahren nach vorstehendem Anspruch, **dadurch gekennzeichnet, dass** das Laufdatum auch nach der fehlerhaften Übertragung eines Übertragungsprotokollrahmens im nächtens Zyklus geändert wird.

5. Verfahren nach einem der zwei vorstehenden Ansprüche, wobei als Sicherheitsdaten in dem dem Sicherheitsteilnehmer zugeordneten Zeitschlitz zusätzlich Prozessdaten für Teilnehmer, die sicherheitsrelevante Prozessdaten verarbeiten können, eingebettet werden.

6. Verfahren nach vorstehendem Anspruch, wobei als zusätzliche Prozessdaten in diesem Zeitschlitz Steuerungsdaten eingebettet werden.

7. Verfahren nach einem der vier vorstehenden Ansprüche, **dadurch gekennzeichnet, dass** die Sicherheitsdaten in dem Zeitschlitz des Sicherheitsteilnehmers zur Generierung von zweiten Sicherungsdaten verwendet werden, die gemeinsam mit den Sicherheitsdaten in dem Zeitschlitz eingebettet werden,
und/oder
ferner **dadurch gekennzeichnet, dass** das während eines Datenübertragungszyklus übertragene Laufdatum des Sicherheitsteilnehmers von anderen Teilnehmern, die sicherheitsrelevante Prozessdaten verarbeiten können, für den darauffolgenden Datenübertragungszyklus, sofern sicherheitsrelevante Prozessdaten übertragen werden sollen, zur Generierung der ersten Sicherungsdaten verwendet wird.

8. Verfahren nach einem der vorstehenden Ansprüche, wobei zur Generierung der ersten Sicherungsdaten die jeweiligen zu sichernden sicherheitsrelevanten Prozessdaten einbezogen werden.

9. Verfahren nach einem der vorstehenden Ansprüche, wobei zur Generierung der ersten Sicherungsdaten zusätzlich wenigstens eine Sicherungskennung einbezogen wird, die einen jeweiligen Slave, welchem sicherheitsrelevante Prozessdaten zuzuordnen sind, identifizieren.

10. Verfahren nach vorstehendem Anspruch, wobei der einem jeweiligen Teilnehmer zugeordnete Zeitschlitz eine vorbestimmte Position innerhalb des Übertragungsprotokollrahmens einnimmt und die Sicherungskennung zumindest unter Verwendung einer vorgegebenen von diesen Positionen gebildet wird.

11. Verfahren nach einem der vorstehenden Ansprüche, wobei jeder Übertragungsprotokollrahmen insgesamt mit dritten Sicherungsdaten, die vom Master unter Verwendung aller darin übertragener Daten generiert werden, gesichert wird und alle Slave die in einem Übertragungsprotokollrahmen enthaltenen Daten mitlesen können,
und/oder
Zeitschlitze, die Teilnehmern zugeordnet sind, welche sicherheitsrelevante Prozessdaten verarbeiten können, innerhalb des Übertragungsprotokollrahmens vor Zeitschlitzen angeordnet werden, die Teilnehmern zugeordnet sind, welche keine sicherheitarelevanten Prozessdaten verarbeiten können.

12. Übertragungssystem zur Durchführung des Verfahrens nach einem der vorstehenden Ansprüche, umfassend wenigstens einen als Bus-Master fungierenden Teilnehmer und wenigstens einen als Slave fungierenden Teilnehmer, die an einen gemeinsamen Bus zur protokollapezifisch zyklischen Datenübertragung angeschaltet sind, wobei innerhalb eines Übertragungsprotokollrahmens jedem Slave während eines Datenübertragungszyklus ein Zeitschlitz zugeordnet wird, der unabhängig von den zu übertragenden Daten stets die gleiche Anzahl von Bits aufnehmen kann,
**dadurch gekennzeichnet, dass**
durch den Bus-Master jeder Datenaustauschzyklus mit der Übertragung einer Adresse und eines Funktionscodes einleitet wird, wobei
in einem Zeitschlitz, innerhalb welchen sicherheitsrelevante Prozessdaten während eines Datenübertragungszyklus von einem Slave sicher an wenigstens einen weiteren Teilnehmer übertragen werden sollen oder während eines Datenübertragungszyklus von einem Teilnehmer sicher an wenigstens einen Slave übertragen werden sollen, zur Erkennung einer fehlerfreien Übertragung dieser sicherheitsrelevanten Prozessdaten jeweils zusätzlich erste Sicherungsdaten eingebettet sind.

13. Übertragungssystem nach vorstehendem Anspruch, ferner **dadurch gekennzeichnet, dass** ein Teilnehmer als Sicherheitsteilnehmer und zum Einbetten von Sicherheitsdaten während jedes Datenübertragungszyklus in den Übertragungsprotokollrahmen ausgebildet ist, und zumindest die weiteren Teilnehmer, die sicherheitsrelevante Prozessdaten verarbeiten können, zum Auslesen von Sicherheitsdaten des Sicherheitsteilnehmers während eines jeweiligen Zyklus und zum Einsetzen von ausgelesen Sicherheitsdaten für die Generierung der ersten Sicherungsdaten während eines nachfolgenden Zyklus ausgebildet sind.

14. Übertragungssystem nach vorstehendem Anspruch, ferner **dadurch gekennzeichnet, dass** dem Sicherheitsteilnehmer innerhalb des Übertragungsprotokollrahmens ein Zeitschlitz fest zugeordnet ist, und der Sicherheitsteilnehmer zur Generierung eines sich zyklisch jeweils verändernden Laufdatums ausgebildet ist,
und/oder
wobei der Sicherheitsteilnehmer zur Generierung und Einbettung von Steuerungsdaten ausgebildet ist, und/oder
**dadurch gekennzeichnet, dass** der Sicherheitsteilnehmer ausgebildet ist, unter Nutzung der Sicherheitadaten zweite Sicherungsdaten zu generieren und diese gemeinsam mit den Sicherheitsdaten in dem Zeitschlitz einzubetten.

15. Übertragungssystem nach einem der vorstehenden Ansprüche 12 bis 14, wobei die Teilnehmer, die sicherheitsrelevante Prozesadaten verarbeiten können ausgebildet sind, zur Generierung der ersten Sicherungsdaten zusätzlich wenigstens eine Sicherungskennung einbeziehen, die einen jeweiligen Slave, welchem sicherheitsrelevante Prozessdaten zuzuordnen sind, identifizieren,
und/oder
wobei jeder Übertragungsprotokollrahmen insgesamt mit dritten Sicherungsdaten abgesichert ist, der Master unter Verwendung aller darin übertragener Daten zum Generieren dieser dritten Sicherungsdaten und alle Slaves zum Mitlesen der in einem
Übertragungsprotokollrahmen enthaltenen Daten und zum Generieren entsprechender dritter Sicherungsdaten ausgebildet sind.

16. Übertragungssystem nach einem der vorstehenden Ansprüche 12 bis 14, wobei die Teilnehmer, die sicherheitsrelevante Prozessdaten verarbeiten können ausgebildet sind, zur Generierung der ersten Sicherungsdaten zusätzlich wenigstens eine Sicherungskennung einbeziehen, die einen jeweiligen Slave, welchem sicherheitsrelevante Prozessdaten zuzuordnen sind, identifizieren,
und/oder
wobei Zeitschlitze, die Teilnehmern zugeordnet sind, welche sicherheitsrelevante Prozessdaten verarbeiten können, innerhalb des Übertragungsprotokollrahmens vor Zeitschlitzen angeordnet sind, die Teilnehmern zugeordnet sind, welche keine sicherheitsrelevanten Prozessdaten verarbeiten können.

## Claims

1. Method for secure transmission of process data to be transmitted cyclically in a cyclical data transmission to be performed protocol-specifically via a transmission channel between one user functioning as a bus master and at least one user functioning as a slave that are connected to the transmission channel, wherein within a transmission protocol frame, a time slot that can always accommodate the same number of bits independently of the data to be transmitted is assigned to each slave during a data transmission cycle,
**characterized in that**
each data exchange cycle is initiated by the bus master with the transmission of an address and a function code, wherein
for safety-relevant process data that is to be transmitted securely during a data transmission cycle from a slave to at least one additional user, or that is to be transmitted securely during a data transmission cycle from a user to at least one slave, additional first protection data for recognizing error-free transmission of this safety-relevant process data is generated and transmitted in each case, wherein the process data to be securely transmitted is embedded together with the respective first protection data into the time slot assigned to the respective slave.

2. Method according to the preceding claim, further **characterized in that** a user is permanently specified as a safety user, and
the first protection data is generated using safety data that was transmitted by the safety user via the transmission channel during a cyclically preceding data transmission cycle, and is read during the transmission cycle at least by users that can handle safety-relevant process data.

3. Method according to the preceding claim, further **characterized in that** a time slot inside the transmission protocol frame is permanently assigned to the safety user, wherein the safety data of the safety user that is employed for generating the first protection data is embedded in the time slot associated with the safety user and comprises a run date that changes cyclically with each data transmission cycle, wherein this time slot is also read during the transmission cycle at least by users that can handle safety-relevant process data.

4. Method according to the preceding claim, **characterized in that** the run date is also changed in the next cycle following the faulty transmission of a transmission protocol frame.

5. Method according to one of the two preceding claims, wherein process data of users that can handle safety-relevant process data is also embedded as safety data in the time slot assigned to the safety user.

6. Method according to the preceding claim, wherein control data is embedded in this time slot as additional process data.

7. Method according to one of the four preceding claims, **characterized in that** the safety data in the time slot of the safety user is employed for generating second protection data, which is embedded in the time slot together with the safety data, and/or
further **characterized in that** the run date of the safety user that is transmitted during a transmission cycle is employed by other users that can handle safety-relevant process data to generate the first protection data for the next data transmission cycle, insofar as safety-relevant process data is to be transmitted.

8. Method according to one of the preceding claims, wherein the respective safety-relevant process data to be protected is included for generating the first protection data.

9. Method according to one of the preceding claims, wherein at least one protection identifier that identifies a respective slave to which safety-relevant process data is to be assigned is used for generating the first protection data,

10. Method according to the preceding claim, wherein the time slot assigned to a respective user occupies a predetermined position inside the transmission protocol frame, and the protection identifier is formed at least using a predetermined position among these positions.

11. Method according to one of the preceding claims, wherein each transmission protocol frame is protected as a whole with third protection data generated by the master using all the data transmitted therein, and all slaves can read the data contained in a transmission protocol frame and/or
time slots assigned to the users that can handle safety-relevant process data are arranged inside the transmission protocol frame ahead of time slots assigned to users that cannot handle safety-relevant process data.

12. Transmission system for performing the method according to one of the preceding claims, comprising
at least one user functioning as a bus master and
at least one user functioning as a slave that are connected to a common bus for protocol-specific cyclical data transmission, wherein within a transmission protocol frame, a time slot that can always accommodate the same number of bits independently of the data to be transmitted is assigned to each slave during a data transmission cycle,
**characterized in that**
each data exchange cycle is initiated by the bus master with the transmission of an address and a function code, wherein
in a time slot, inside of which safety-relevant process data that is to be transmitted securely during a data transmission cycle from a slave to at least one additional user, or that is to be transmitted securely during a data transmission cycle from a user to at least one slave, respective additional first protection data for recognizing error-free transmission of this safety-relevant process data is embedded.

13. Transmission system according to the preceding claim, further **characterized in that** one user is formed as a safety user and for embedding safety data into the transmission protocol frame during each data transmission cycle, and at least the additional users that can handle safety-relevant process data are formed for reading out safety data of the safety user during a respective cycle and for using read-out safety data for generating the first protection data during a subsequent cycle.

14. Transmission system according to the preceding claim, further **characterized in that** a time slot inside the transmission protocol frame is permanently assigned to the safety user, and the safety user is formed for generating a run date varying cyclically in each case
and/or
wherein the safety user is formed for generating and embedding control data
and/or
**characterized in that** the safety user is formed to generate second protection data by using the safety data and to embed it in the time slot together with the safety data.

15. Transmission system according to one of the preceding claims 12 to 14, wherein, for generating the first protection data, the users that can handle safety-relevant process data additionally include at least one protection identifier that identifies each slave to which safety-relevant process data is to be assigned
and/or
wherein each transmission protocol frame is protected as a whole with third protection data, the master is formed to generate this third protection data by using all the data transmitted therein, and all slaves are formed to read the data contained in a transmission protocol frame and to generate corresponding third protection data.

16. Transmission system according to one of the preceding claims 12 to 14,
wherein, for generating the first protection data, the users that can handle safety-relevant process data additionally include at least one protection identifier that identifies each slave to which safety-relevant process data is to be assigned
and/or
wherein time slots assigned to the users that can handle safety-relevant process data are arranged inside the transmission protocol frame ahead of time slots assigned to users that cannot handle safety-relevant process data.

## Revendications

1. Procédé pour la transmission sécurisée de données de processus à transmettre cycliquement lors d'une transmission cyclique de données à exécuter conformément à un protocole spécifique via un canal de transmission au moins entre un abonné ayant fonction de maître de bus et au moins un abonné ayant fonction d'esclave, lesquels sont connectés au canal de transmission, dans lequel
un créneau temporel est attribué à chaque esclave à l'intérieur d'un cadre de protocole de transmission pendant un cycle de transmission de données, ledit créneau temporel pouvant toujours recevoir le même nombre de bits indépendamment des données à transmettre,
**caractérisé en ce que** :
le maître de bus introduit chaque cycle de communication de données par la transmission d'une adresse et d'un code de fonction, dans lequel,
pour des données de processus relatives à la sécurité, devant être transmises de manière sécurisée d'un esclave à au moins un autre abonné pendant un cycle de transmission de données ou devant être transmises de manière sécurisée d'un abonné à au moins un esclave pendant un cycle de transmission de données, pour la reconnaissance d'une transmission sans erreur desdites données de processus relatives à la sécurité, des premières données de sauvegarde sont générées en complément et transmises conjointement, les données de processus à transmettre de manière sécurisée étant incorporées avec les premières données de sauvegarde générées à cet effet dans le créneau temporel attribué à l'esclave correspondant.

2. Procédé selon la revendication précédente, **caractérisé en outre en ce qu'**un abonné est fixement défini en tant qu'abonné de sécurité, et les premières données de sauvegarde sont générées en utilisant des données de sécurité transmises par l'abonné de sécurité via le canal de transmission pendant un cycle de transmission de données cycliquement précédent, et lues au moins par des abonnés pouvant traiter des données de processus relatives à la sécurité pendant le cycle de transmission.

3. Procédé selon la revendication précédente, **caractérisé en outre en ce qu'**un créneau temporel est fixement attribué à l'abonné de sécurité à l'intérieur du cadre de protocole de transmission, les données de sécurité de l'abonné de sécurité utilisées pour la génération des premières données de sauvegarde étant incorporées dans ledit créneau temporel attribué et comprenant une date d'exécution variant cycliquement avec chaque cycle de transmission de données, ledit créneau temporel étant lu au moins par des abonnés pouvant traiter des données de processus relatives à la sécurité pendant le cycle de transmission.

4. Procédé selon la revendication précédente, **caractérisé en ce que** la date d'exécution est modifiée lors du cycle suivant même après transmission défectueuse d'un cadre de protocole de transmission.

5. Procédé selon l'une des deux revendications précédentes, dans lequel des données de processus sont incorporées en complément en tant que données de sécurité dans le créneau temporel attribué à l'abonné de sécurité, pour les abonnés pouvant traiter des données de processus relatives à la sécurité.

6. Procédé selon la revendication précédente, dans lequel des données de commande sont incorporées en tant que données de processus complémentaires dans ledit créneau temporel.

7. Procédé selon l'une des quatre revendications précédentes, **caractérisé en ce que** les données de sécurité sont utilisées dans le créneau temporel de l'abonné de sécurité pour la génération de deuxièmes données de sauvegarde incorporées dans le créneau temporel avec les données de sécurité,
et/ou
**caractérisé en outre en ce que** la date d'exécution de l'abonné de sécurité transmise pendant un cycle de transmission de données est utilisée par d'autres abonnés pouvant traiter des données de processus relatives à la sécurité, pour la génération des premières données de sauvegarde pour le cycle de transmission de données consécutif, si des données de processus relatives à la sécurité doivent être transmises.

8. Procédé selon l'une des revendications précédentes, dans lequel les données de processus relatives à la sécurité à sauvegarder sont intégrées pour la génération des premières données de sauvegarde.

9. Procédé selon l'une des revendications précédentes, dans lequel au moins une identification de sauvegarde est intégrée en complément pour la génération des premières données de sauvegarde, laquelle identifie un esclave correspondant auquel des données de processus relatives à la sécurité ont à être attribuées.

10. Procédé selon la revendication précédente, dans lequel le créneau temporel à attribuer à un abonné correspondant occupe une position prédéterminée à l'intérieur du cadre de protocole de transmission et identification de sauvegarde est formée au moins en utilisant une position définie parmi lesdites positions.

11. Procédé selon l'une des revendications précédentes, dans lequel chaque cadre de protocole de transmission est sauvegardé avec des troisièmes données de sauvegarde, générées par le maître en utilisant toutes les données transmises à l'intérieur de celui-ci, et tous les esclaves peuvent lire conjointement les données contenues dans un cadre de protocole de transmission,
et/ou
des créneaux temporels attribuée à des abonnés pouvant traiter des données de processus relatives à la sécurité, sont disposés à l'intérieur du cadre de protocole de transmission avant des créneaux temporels attribués à des abonnés ne pouvant pas traiter de données de processus relatives à la sécurité.

12. Système de transmission pour l'exécution du procédé selon l'une des revendications précédentes, comprenant au moins un abonné ayant fonction de maître de bus et au moins un abonné ayant fonction d'esclave, lesquels sont connectés à un bus commun pour la transmission cyclique de données conformément à un protocole spécifique, dans lequel un créneau temporel est attribué à chaque esclave à l'intérieur d'un cadre de protocole de transmission pendant un cycle de transmission de données, ledit créneau temporel pouvant toujours recevoir le même nombre de bits indépendamment des données à transmettre,
**caractérisé en ce que** :
le maître de bus introduit chaque cycle de communication de données par la transmission d'une adresse et d'un code de fonction, et dans lequel,
des premières données de sauvegarde sont incorporées en complément dans un créneau temporel, à l'intérieur duquel des données de processus relatives à la sécurité doivent être transmises de manière sécurisée d'un esclave à au moins un autre abonné pendant un cycle de transmission de données ou doivent être transmises de manière sécurisée d'un abonné à au moins un esclave pendant un cycle de transmission de données, pour la reconnaissance d'une transmission sans erreur desdites données de processus relatives à la sécurité.

13. Système de transmission selon la revendication précédente, **caractérisé en outre en ce qu'**un abonné est configuré dans le cadre de protocole de transmission en tant qu'abonné de sécurité et pour l'incorporation de données de sécurité pendant chaque cycle de transmission de données, et **en ce qu'**au moins les autres abonnés pouvant traiter des données de processus relatives à la sécurité sont configurés pour la lecture de données de sécurité de l'abonné de sécurité pendant un cycle et pour l'application de données de sécurité lues pour la génération des premières données de sauvegarde pendant un cycle consécutif.

14. Système de transmission selon la revendication précédente, **caractérisé en outre en ce qu'**un créneau temporel est fixement attribué à l'abonné de sécurité à l'intérieur du cadre de protocole de transmission, et l'abonné de sécurité est configuré pour la génération d'une date d'exécution variant cycliquement,
et/ou
dans lequel l'abonné de sécurité est configuré pour la génération et l'incorporation de données de commande,
et/ou
**caractérisé en ce que** l'abonné de sécurité est configuré pour générer des deuxièmes données de sauvegarde en utilisant les données de sécurité, et pour incorporer celles-ci dans le créneau temporel avec les données de sécurité.

15. Système de transmission selon l'une des revendications 12 à 14, dans lequel les abonnés pouvant traiter des données de processus relatives à la sécurité sont configurés pour intégrer en complément au moins une identification de sauvegarde pour la génération des premières données de sauvegarde, laquelle identifie un esclave correspondant auquel des données de processus relatives à la sécurité ont à être attribuées,
et/ou
dans lequel chaque cadre de protocole de transmission est globalement sauvegardé avec des troisièmes données de sauvegarde, le maître est configuré en utilisant toutes les données transmises à l'intérieur de celui-ci pour la génération desdites troisièmes données de sauvegarde, et tous les esclaves sont configurés pour la lecture conjointe des données contenues dans un cadre de protocole de transmission et pour la génération de troisièmes données de sauvegarde correspondantes.

16. Système de transmission selon l'une des revendications 12 à 14, dans lequel les abonnés pouvant traiter des données de processus relatives à la sécurité sont configurés pour intégrer en complément au moins une identification de sauvegarde pour la génération des premières données de sauvegarde, laquelle identifie un esclave correspondant auquel des données de processus relatives à la sécurité ont à être attribuées,
et/ou
dans lequel des créneaux temporels attribués à des abonnés pouvant traiter des données de processus relatives à la sécurité, sont disposés à l'intérieur du cadre de protocole de transmission avant des créneaux temporels attribués à des abonnés ne pouvant pas traiter de données de processus relatives à la sécurité.
